(19) Europäisches Patentamt
European Patent Office
Office européen des brevets

(11) Publication number: **0 022 188**
**B1**

(12) # EUROPEAN PATENT SPECIFICATION

(45) Date of publication of patent specification: **03.10.84**

(51) Int. Cl.$^3$: **G 03 C 1/68**

(21) Application number: **80103303.6**

(22) Date of filing: **13.06.80**

(54) **Co-initiator compositions for photopolymerization containing 3-acyl-substituted coumarins, photopolymerizable composition and photographic element.**

(30) Priority: **18.06.79 US 49661**
**16.11.79 US 95171**

(43) Date of publication of application:
**14.01.81 Bulletin 81/02**

(45) Publication of the grant of the patent:
**03.10.84 Bulletin 84/40**

(84) Designated Contracting States:
**BE DE FR GB IT NL SE**

(56) References cited:
**FR-A-2 216 304**
**US-A-3 637 385**
**US-A-3 756 827**
**US-A-4 071 424**
**US-A-4 147 552**

(73) Proprietor: **EASTMAN KODAK COMPANY**
**343 State Street**
**Rochester New York 14650 (US)**

(72) Inventor: **Specht, Donald Paul**
**Kodak Park**
**Rochester New York (US)**
Inventor: **Farid, Samir Yacoub**
**Kodak Park**
**Rochester New York (US)**
Inventor: **Payne, Kenneth Lynn**
**Kodak Park**
**Rochester New York (US)**
Inventor: **Houle, Conrad Gerard**
**Kodak Park**
**Rochester New York (US)**

(74) Representative: **Brandes, Jürgen, Dr. Dipl.-Chem. et al**
**Patentanwälte H. Bartels, Dipl.-Chem. Dr. Brandes Dr.-Ing. Held, Dipl.-Phys. Wolff**
**Thierschstrasse 8**
**D-8000 München 22 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 022 188 B1

**Description**

Field of the Invention

This invention relates to co-initiator compositions used to photoinitiate the polymerization of addition polymerizable compounds containing ethylenic unsaturation.

Background of the Invention

Mixed photoinitiators, sometimes known as co-initiators, have been disclosed for use with polymerizable monomers. Co-initiators usually comprise two compounds, a light-sensitive compound sometimes identified as a sensitizer, and an activator compound which in the presence of the sensitizer is not significantly directly excited by the activating radiation. It is generally accepted that the activator forms a free-radical in response to the exposure of the sensitizer. Known classes of such activators include amines, sulfinic acid and sulfinic acid esters, sulfones, $\alpha$- and $\beta$-dicarbonyls such as bornanedione and acetylacetone, phosphines, phosphites, stannates, and hexa-arylbi-imidazoles. Recently, a number of aromatic carbonyl compounds have been disclosed as useful sensitizers with a variety of activators to form co-photoinitiators of many kinds. Such mixtures are described in Ledwith, *J. Oil Col. Chem. Assoc., 59,* p. 157—165 (1976). The carbonyl compounds specifically identified are phenones, including cyclic ketones, such as 4,4′-dimethylaminobenzophenone (Michler's ketone), fluorenones, anthraquinones and anthrones.

U.S. Patent 4,147,522 issued April 3, 1979 discloses the use of 3-acyl-substituted coumarin compounds as sensitizers for photocrosslinkable and photopolymerizable ethylenically-unsaturated compounds. Further, it suggests that a mixture of coumarin compounds such as 3 - benzoyl - 7 - methoxycoumarin and 3,3′ - carbonylbis(7 - diethyl - aminocoumarin) may be useful to increase the speed and to sensitize crosslinkable polymers over a broader range of exposing radiation than is achieved by either compound alone.

However, 3,3′-carbonylbis(7-diethylaminocoumarin) is an amine and, as such, might be expected to act as an activator in a co-initiator system with another aromatic carbonyl compound as a sensitizer. Surprisingly, when 3,3′-carbonylbis(7-diethylaminocoumarin) was tested as an activator in combination with 3-benzoyl-7-methoxy-coumarin as a sensitizer, the speed of photopolymerization of a mixture of addition polymerizable monomers was only about 0.08 that produced by the well known co-initiator combination of Michler's ketone and benzophenone.

There is thus a need for new co-initiator compositions which are responsive to visible radiation and which achieve fast speeds.

Summary of the Invention

In accordance with the present invention there is provided a co-initiator composition for the photopolymerization of an addition polymerizable compound or mixture of such compounds containing ethylenic-unsaturation, comprising a sensitizer which is a photo-excitable aromatic carbonyl compound and an activator compound which is responsive in the presence of a photo-excited form of said carbonyl compound to form a free-radical; characterized in that

a) said aromatic carbonyl compound is a 3-acyl-coumarin having the formula:

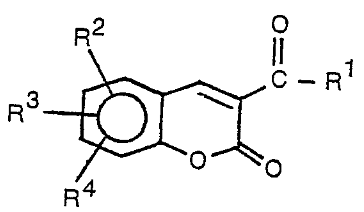

(I)

wherein:

$R^1$ is an aromatic carbocyclic or heterocyclic group having from 5 to 20 ring atoms, which aromatic group is conjugated with the carbonyl group either directly or through an alkenylene group;

$R^2$, $R^3$ and $R^4$ are each independently: hydrogen; hydroxy; alkylamino, dialkylamino, or alkoxy containing from 1 to 5 carbon atoms in the alkyl portion; acyloxy; a heterocyclic group of one or more saturated or unsaturated rings containing from 5 to 10 ring atoms; or $R^2$ and $R^3$ and/or $R^3$ and $R^4$, when taken together comprise the non-metallic atoms necessary to complete one or more fused aryl or fused saturated or unsaturated heterocyclic rings containing from 5 to 10 ring atoms; and

b) said activator compound is selected from an amino-derivative of acetic acid, a phosphine, a phosphite, a bismuthine, an arsine, a stibine, a sulfinic acid, a sulfinic acid ester, a sulfone, 9-fluorenone, 2,3-bornanedione and an amine according to one of the formulas:

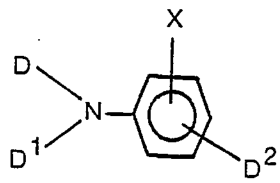 or 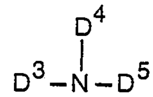

wherein:

D and $D^1$ are each independently an alkyl group having from 1 to 12 carbon atoms or, when taken together, the atom necessary to complete a heterocyclic group having from 5 to 10 nuclear atoms;

$D^2$ is an alkyl group having from 1 to 3 carbon atoms, a hydroxyalkyl group, a formyl group, a

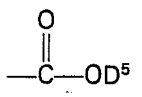 group, or a 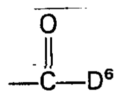

group;

$D^3$ is hydrogen, an alkyl group having from 1 to 12 carbon atoms, an aralkyl group having from 1 to 3 carbon atoms in the alkyl portion and from 6 to 10 carbon atoms in the aryl portion;

$D^4$ is an alkyl group having from 1 to 12 carbon atoms or an aralkyl group having from 1 to 12 atoms in the alkyl portion and from 6 to 10 carbon atoms in the aryl portion;

$D^5$ is an aryl group having from 6 to 10 carbon atoms, an alkyl group having from 1 to 15 carbon atoms, or an alkyl group substituted with an aryl group, a 2-phthalimido group, a methacryloyloxy group or a group of the formula

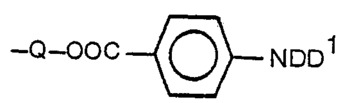

wherein D and $D^1$ are as defined above and Q is a linking group;

$D^6$ is hydrogen, an alkyl group having from 1 to 3 carbon atoms, an aryl group having from 6 to 10 nuclear carbon atoms or a $-CH_2COOD^7$ group wherein $D^7$ is hydrogen or an alkyl group having from 1 to 3 carbon atoms; and

X is hydrogen or a halogen,

all carbocyclic, heterocyclic and aryl groups in a) and b) being optionally substituted and all alkenyl groups being optionally substituted by aryl or alkyl.

D and $D^1$ may represent for example methyl, ethyl, propyl, octyl or dodecyl.

$D^2$ may represent for example methyl, ethyl, propyl, hydroxymethyl or hydroxyethyl.

$D^3$ may represent for example methyl, ethyl, propyl, octyl, dodecyl, benzyl or phenethyl.

$D^4$ may represent for example benzyl or phenethyl.

$D^5$ may represent for example methyl, propyl, isopropyl, butyl, octyl, dodecyl or phenyl.

Q may represent for example alkylene, unsaturated alkylene or phenylenebisalkylene.

$D^6$ may represent for example methyl, ethy, propyl or 4-dialkylaminophenyl.

## Description of the Invention

As used herein, a "co-initiator composition" is a combination of at least two components which interact on exposure to activating radiation to initiate the addition polymerization of simple unsaturated compounds or vinyl monomers. Although we do not wish to be bound by any specific mechanism, one components of the co-initiator composition, hereinafter referred to as the "sensitizer" is light-sensitive and appears to be raised to an excited energy state on absorption of activating radiation. The other component, hereinafter referred to as the "activator" appears to interact with an excited sensitizer to generate free-radicals. It is well known, of course, that addition polymerization can be initiated by free-radicals.

The co-initiators described above photoinitiate the polymerization of a wide variety of ethylenically-unsaturated compounds when exposed to radiation within the range of from 250 nm to 550 nm with a speed that is substantially greater than that provided by the combination of 3 - benzoyl - 7 - methoxycoumarin and 3,3' - carbonylbis(7 - diethylaminocoumarin) which is suggested in U.S. Patent 4,147,522.

Certain 3-acyl-coumarins are effective, as the sensitizer portion of a co-initiator composition that also includes a free-radical photopolymerization activator, in effecting addition polymerization of ethylenically-unsaturated compounds with a speed exceeding that achievable with the co-initiator composition of Michler's ketone and benzophenone. In many instances, it is believed that the speed of the present co-initiators far exceeds that available from any previously known co-initiator composition.

The term "addition polymerizable" or "addition-polymerization" refers to the chain reaction that occurs wherein a single photon causes the addition of more than one recurring unit to a growing

polymer, in contrast with crosslinking wherein a single photon creates only one cross-link between polymer chains.

As used herein, "carbocyclic", "aryl" and "heterocyclic" include substituted as well as unsubstituted carbocyclic, aryl and heterocyclic, respectively. Suitable substituents include alkoxy containing from 1 to 5 carbon atoms, such as methoxy, ethoxy, propoxy, butoxy, and pentyl; sulfonates such as fluorosulfonate; cyano; dialkylamino such as dimethylamino, diethylamino and dipropylamino; halo such as chloro and bromo; nitro; hydroxy; alkyl of from 1 to 5 carbon atoms, such as methyl, ethyl and propyl; and trihalomethyl. Also, alkenyl includes aryl or alkyl substituted alkeny, for example styryl.

The photopolymerizable composition of the invention comprises an addition polymerizable compound containing ethylenic unsaturation, and a co-initiator composition comprising an admixture of a 3-acylcoumarin sensitizer and a photopolymerization activator selected from the group set forth hereinbefore. Particularly useful 3-acylcoumarins are those bearing an amino substituent in the 5, 6, 7 or 8 position.

Any addition polymerizable compound containing ethylenic unsaturation can be photopolymerized using the co-initiators of this invention. Preferred are simple compounds, or monomers as they are sometimes denominated, containing ethylenic unsaturation, as well as polymers containing end groups or pendant groups terminating with ethylenic unsaturation. For example, the phrase "addition polymerizable compounds" includes polymers having recurring units with the structure

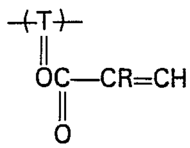

(II)

wherein T is any group capable of forming the backbone of a polymer and R is hydrogen or methyl.

Other examples of useful addition polymerizable compounds containing ethylenic unsaturation include monomeric acrylates, acrylamides, methacrylates, methacrylamides, allyl compounds, vinyl ethers, vinyl esters, N-vinyl compounds, styrenes, acrylonitriles and crotonates. Many examples of each of these classes are well known, such as those listed for example in British Patent Specification No. 1,534,137.

A highly preferred class of addition polymerizable compounds encompasses the acrylate compounds. Acrylates have been used in photopolymerization for years and a wide variety have been identified in the literature. Particularly useful examples include alkyl acrylates containing from 1 to 10 and most preferably 1 to 5 carbon atoms in the alkyl portion, such as methyl acrylate and ethyl methacrylate; pentaerythritol tri- and tetraacrylates and methacrylates; esters of polyols including glycol diacrylates and dimethacrylates, such as tripropylene glycol diacrylates, tetraethylene glycol diacrylate and triethylene glycol dimethacrylate; alkanediol diacrylates such as hexanediol diacrylates; polyether diacrylates such as that obtainable from UCB, a division of Chimique Chausse de Charleroi, Brussels, Belgium under the trade name "Ebecryl 210"; and mixtures of the above.

The sensitizer component of the co-initiator composition of this invention is a 3-acyl-substituted coumarin as defined hereinbefore. A preferred group of such coumarins are those having the formula:

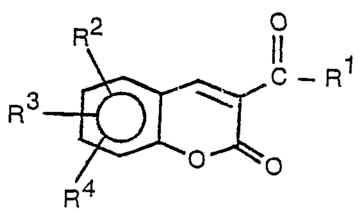

(I)

wherein

$R^1CO$— is: benzoyl, furoyl, benzofuroyl, thenoyl, cinnnamoyl, thienylacryloyl, naphthylacryloyl, cinnamylideneacryloyl, and pyridylcarbonyl which can be optionally substituted with cyano, nitro, halo, dialkylamino, alkoxy, trihalomethyl or fluorosulfonyl groups; and each of $R^2$, $R^3$ and $R^4$ is independently as defined hereinbefore, such as propylamino, dimethylamino, diethylamino, methoxy, ethoxy, n-propoxy, acetoxy, pyridyl, pyrrolinyl and pyrrolidyl. A useful example of a 3-acylcoumarin comprising a fused heterocyclic group is found in a coumarin having the structural formula:

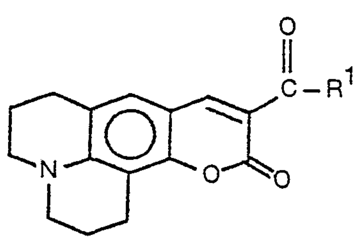

(III)

which is a 9-acyl-substituted 1,2,4,5-tetrahydro-3H, 6H, 10H [1]benzopyrano[9,9a, 1-gh]quinolazine-10-one.

3-Acylcoumarins which are useful as the sensitizer component of the co-initiator compositions of the invention include:

TABLE I

| | |
|---|---|
| S—1 | 3-benzoyl-7-methoxycoumarin; |
| S—2 | 7-methoxy-3-(4-nitrobenzoyl)coumarin; |
| S—3 | 3-(4-fluorosulfonylbenzoyl)-7-methoxycoumarin; |
| S—4 | 5,7-diethoxy-3-(2-thenoyl)coumarin; |
| S—5 | 3,3′-carbonylbis(5,7-diethoxycoumarin); |
| S—6 | 3,3′-carbonylbis(5,7-di-n-propoxycoumarin); |
| S—7 | 3-benzoyl-5,7-di-n-propoxycoumarin; |
| S—8 | 3-(2-benzofuroyl)-5,7-diethoxycoumarin; |
| S—9 | 3-(4-cyanobenzoyl)-5,7-di-n-propoxycoumarin; |
| S—10 | 3-(4-methoxybenzoyl)-5,7-di-n-propoxycoumarin; |
| S—11 | 3-(4-nitrobenzoyl)-5,7-di-n-propoxycoumarin; |
| S—12 | 7-methoxy-3-(3-pyridylcarbonyl)coumarin; |
| S—13 | 3,3′-carbonylbis(5,7-dibutoxycoumarin); |
| S—14 | 3,3′-carbonylbis(7-acetoxycoumarin); |
| S—15 | 3,3′-carbonylbis(5,7,7′-trimethoxycoumarin); |
| S—16 | 3-(3-trifluoromethylbenzoyl)-5,7-di-n-propoxycoumarin; |
| S—17 | 3-benzoyl-5,7-dimethoxy coumarin; |
| S—18 | 3-benzoyl-5,7-diethoxycoumarin; |
| S—19 | 3-benzoyl-6-methoxycoumarin; |
| S—20 | 3-benzoyl-8-ethoxycoumarin; |
| S—21 | 3-benzoylbenzo[f]coumarin; |
| S—22 | 3-benzoyl-7-hydroxycoumarin; |
| S—23 | 3-(4-ethoxybenzoyl)-7-methoxycoumarin; |
| S—24 | 7-acetoxy-3-benzoylcoumarin; |
| S—25 | 7-methoxy-3-(4-methoxybenzoyl)coumarin; |
| S—26 | 3-(4-ethoxycinnamoyl)-7-methoxycoumarin; |
| S—27 | 3,3′-carbonylbiscoumarin; |
| S—28 | 3,3′-carbonylbis(7-methoxycoumarin); |
| S—29 | 3,3′-carbonylbis(6-methoxycoumarin); |
| S—30 | 3,3′-carbonylbis(5,7-dimethoxycoumarin); and |
| S—31 | 3,3′-carbonylbis(5,7-di-iso-propoxycoumarin). |

Highly preferred sensitizers for purposes of this invention include coumarins substituted in the 5, 6, 7 or 8 position with an amino group. Such coumarins provide significant absorption of radiation at wavelengths of 366, 405, 436, and 547 nm which allows use of broad-spectrum light sources such as xenon, mercury, or halogen lamps as well as an argon laser. These sensitizers are particularly useful in co-initiator compositions containing amino-substituted acetic acid derivatives as activators. Typical amino-substituted coumarins include:

TABLE II

| | |
|---|---|
| S—32 | 3-benzoyl-7-diethylaminocoumarin; |
| S—33 | 7-diethylamino-3-(4-iodobenzoyl)coumarin; |
| S—34 | 7-diethylamino-3-(4-dimethylaminobenzoyl)coumarin; |
| S—35 | 7-dimethylamino-3-(2-thenoyl)coumarin; |
| S—36 | 7-diethylamino-3-(2-furoyl)coumarin; |
| S—37 | 3-(2-benzofuroyl)-7-diethylaminocoumarin; |
| S—38 | 7-diethylamino-3-(2-methoxybenzoyl)coumarin; |
| S—39 | 3,3′-carbonylbis(7-diethylaminocoumarin); |
| S—40 | 3-(2-benzofuroyl)-7-(1-pyrrolidinyl)coumarin; |
| S—41 | 3-cinnamoyl-7-diethylaminocoumarin; |
| S—42 | 3-(4-diethylaminocinnamoyl)-7-diethylaminocoumarin; |
| S—43 | 7-diethylamino-3-(4-morpholinocinnamoyl)coumarin; |
| S—44 | 7-diethylamino-3-(4-dimethylaminocinnamylideneacetyl)coumarin; |
| S—45 | 9-(4-diethylaminocinnamoyl)-1,2,4,5-tetrahydro-3H,6H,10H[1]benzopyrano[6,7,8-ij]quinolizine-10-one; |
| S—46 | 9-[3-(9-julomidyl)acryloyl]-1,2,4,5-tetrahydro-3H,6H,10H,[1]benzopyrano[6,7,8-ij]quinolizine-10-one; |
| S—47 | 7-diethylamino-3-(3-fluorosulfonylbenzoyl)coumarin; |
| S—48 | 9-(7-n-propylamino-3-coumarinoyl)-1,2,4,5-tetrahydro-3H,6H,10H[1]benzopyrano[6,7,8-ij]quinolizine-10-one; |
| S—49 | 3-(2-benzofuryl)acryloyl-7-diethylaminocoumarin; |
| S—50 | 7-diethylamino-3-[3-(2-thienyl)acryloyl]coumarin; |
| S—51 | 9-(7-diethylamino-3-coumarinoyl)-1,2,4,5-tetrahydro-3H,6H,10H[1]benzopyrano[6,7,8-ij]quinolizine-10-one; |
| S—52 | 7-dimethylamino-3-[3-(2-thienyl)acryloyl]coumarin; |
| S—53 | 9-[3-(2-thienyl)acryloyl]-1,2,4,5-tetrahydro-3H,6H,10H[1]benzopyrano[6,7,8-ij]quinolizine-10-one; |
| S—54 | 7-diethylamino-3-(4-ethoxycinnamoyl)coumarin; |
| S—55 | 3-(4-bromocinnamoyl)-7-diethylaminocoumarin; |
| S—56 | 7-diethylamino-3-[3-(4-methoxy-1-naphthyl)acryloyl]coumarin; |
| S—57 | 7-diethylamino-3-cinnamylideneacetylcoumarin; |

TABLE II (continued)

| | |
|---|---|
| S—58 | 3-(4-cyanobenzoyl)-7-diethylaminocoumarin; |
| S—59 | 3-benzoyl-7-dimethylaminocoumarin; |
| S—60 | 3-benzoyl-7-pyrrolidinylcoumarin; |
| S—61 | 7-dimethylamino-3-(4-iodobenzoyl)coumarin; |
| S—62 | 7-dimethylamino-3-(4-dimethylaminobenzoyl)coumarin; |
| S—63 | 7-diethylamino-3-(4-nitrobenzoyl)coumarin; |
| S—64 | 7-diethylamino-3-(2-thenoyl)coumarin; and |
| S—65 | 7-pyrrolidinyl-3-(2-thenoyl)coumarin. |

A mixture of two or more of any of the above coumarins can also be used.

Conventional methods can be used to prepare these coumarins. For example, preparations are disclosed in the aforesaid U.S. Patent 4,147,552.

The activator used in the co-initiator composition of this invention is selected from the group consisting of amines as herein defined, amine-substituted acetic acid derivatives, phosphines, phosphites, bismuthines, arsines, stibines, sulfinic acid and sulfinic acid esters, sulfones, 2,3-bornanedione and 9-fluorenone. Of this list, most are known activators for use with other sensitizers. Representative patents detailing numerous examples of such known activators include U.S. Patent Nos. 3,650,927; 3,729,404; and 3,933,682. In addition, Michler's ketone, heretofore known to be a photosensitizer only, is believed to function in this invention as an activator at least in some instances, when used with the coumarin sensitizers listed above.

Representative useful amines falling within structures (IV) and (V) above include ethyl 4-dimethylaminobenzoate; other esters of 4-dimethylaminobenzoic acid, e.g., n-butyl 4-dimethylaminobenzoate, phenethyl 4-dimethylaminobenzoate, 2-phthalimidoethyl 4-dimethylaminobenzoate, 2-methacryloyloxyethyl 4-dimethylaminobenzoate, and pentamethylenebis(4-dimethylamino)benzoate; 4,4'-bis(dimethylamino)-benzophenone; phenethyl and pentamethylene esters of 3-dimethylaminobenzoic acid; 4-dimethylaminobenzaldehyde; 2-chloro-4-dimethylaminobenzaldehyde; 4-dimethylaminoacetophenone; 4-dimethylaminobenzyl alcohol; ethyl (4-dimethylamino)benzoyl acetate; 4-N-piperidinoacetophenone; 4-dimethylaminobenzoin; N,N-dimethyl-4-toluidine; N,N-diethyl-3-phenetidine; tribenzylamine; N,N-dibenzylaniline; N-methyl-N-benzylaniline; 4-bromo-N,N-dimethylaniline; and tridodecylamine.

Still other amines which are useful as activators include polymeric amines such as those described in U.S. Patent 4,133,909, containing, for example, units serived from dimethylaminoethyl acrylate or methacrylate.

A particularly useful class of polymeric amines are latex polymers prepared as described in *Research Disclosure,* Publication No. 15930, July 1977, such as, poly(methyl methacrylate-co-N,N-dimethylaminoethyl methacrylate-co-2-hydroxyethyl methacrylate-co-2-acrylamido-2-methylpropanesulphonic acid) wherein the polymer is modified to include pendant amine groups. When using such a latex, hydrophobic coumarins can be loaded into the latex to provide a water-dispersible composition for coating.

A further preferred class of activators are amino-derivatives of acetic acid having one of the following formulas:

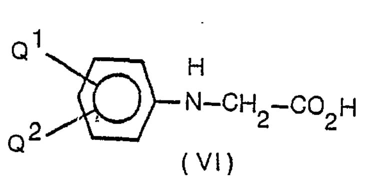

(VI)

or

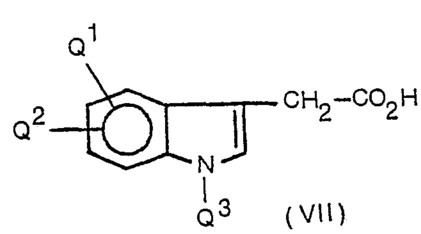

(VII)

wherein $Q^1$ and $Q^2$ are each independently hydrogen; an alkyl, alkoxy or alkylthio group containing from 1 to 5 carbon atoms, for example, methyl, ethyl, propyl, methylthio, propylthio, methoxy, ethoxy, and isopropoxy; an aryl, aryloxy or aroyloxy group containing from 6 to 10 carbon atoms; such as phenyl, naphthyl, phenoxy, and benzoyloxy; hydroxy; or halogen such as chloride and bromide or, when taken together, $Q^1$ and $Q^2$ are the atoms necessary to complete a fused heterocyclic or aromatic ring

containing from 4 to 6 nuclear atoms, for example, benzene, thiophene, furan, pyran, and pyridine; and $Q^3$ is hydrogen or an alkyl group containing from 1 to 5 carbon atoms, for example, methyl, ethyl and propyl. Among the compounds having structure (VI) or (VII), N-phenylglycine and N-methylindole-3-ylacetic acid are preferred. These activators have been found to produce, with 3-acylcoumarins of the type noted above, co-initiator compositions which provide photopolymerization speeds that are unexpectedly improved. In contrast, these selected activators give speeds that are at best only comparable to, and often less than, the speeds provided by many other amine activators, if the acylcoumarin is free of substituents in the 5, 6, 7, or 8 positions.

Highly preferred activators of the above formulas (IV) to (VII) are coumarin-free activators such as N-phenylglycine; indole-3-ylacetic acid; N-methyl-indole-3-ylacetic acid; ethyl and butyl dimethylaminobenzoate; N-methyl-N-benzylaniline; N,N-dimethyl-4-toluidine; 4-hydroxymethyl-N,N-dimethylaniline and N,N-dibenzylaniline.

With respect to phosphines or phosphites as the activator, such phosphines or phosphites can have the structure:

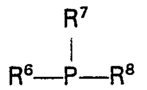

wherein $R^6$, $R^7$ and $R^8$ are the same or different and are each independently: an alkyl or alkoxy group having from 1 to 20 carbon atoms, for example, methyl, ethyl, isooctyl, dodecyl, methoxy, ethoxy, and propoxy; or aryl, alkaryl or aryloxy having from 6 to 10 carbon atoms, e.g., phenyl, tolyl, naphthyl, phenethyl, phenoxy and tolyloxy. Representative examples of such phosphines and phosphites are listed in U.S. Patent 3,729,404, issued on April 24, 1973.

A mixture of two or more activators of the types described above can also be used with the ketocoumarin sensitizers described.

The amount of 3-acylcoumarin sensitizer used in the co-initiator compositions of this invention is not critical. Typically, the 3-acylcoumarin can be present in the photopolymerizable composition in the range of from .0002 to 0.2 mmoles per gram of dry solids. Actual preferred examples tested were in the range of from 0.005 to 0.015 moles per gram.

Of course, sufficient activator needs to be present to allow the free-radical reaction to take place between the excited coumarin and the activator. Thus the activator is typically present in amounts between 0.005 and 2.0 mmoles per gram of dry solids, and preferably between 0.05 and 0.2 mmoles.

In certain applications, a binder can be added to the photopolymerizable composition. The addition polymerizable compound is generally present in from 5 to 100 weight percent of the mixture of that compound and the binder.

The dry thickness of the photopolymerizable composition can vary widely. When coated on a support, the dry thickness is typically between 1 $\mu$m and 1 mm, and is preferably between 20 and 120 $\mu$m. The photopolymerizable composition can be applied to a support by a variety of techniques such as spray-coating, whirl-coating, roll-coating or curtain-coating, all of which are conventional.

Any suitable solvent can be selected for preparing a dope of the photopolymerizable composition to be coated on a support. Typical examples include dichloromethane, acetone, benzene, alcohols, ethers, toluene and the like. The choice will depend, of course, upon the addition polymerizable compound and the co-initiator composition selected as well as upon other components that might be included, e.g., polymeric binders.

The photopolymerizable composition can be coated on a variety of known supports, including photographic supports. Typical useful supports include polymeric film, wood fiber — e.g., paper, metallic sheet and foil, glass and ceramic supports provided with one or more subbing layers to enhance the adhesive, antistatic, dimensional, abrasive, hardness, frictional, and/or other properties of the support surface which might be desired.

Typical polymeric film supports are films of cellulose nitrate and cellulose ester such as cellulose triacetate and diacetate, polystyrene, polyamides, homo- and copolymers of vinyl chloride, poly (vinyl acetal), polycarbonate, homo- and copolymers of olefins, such as polyethylene and polypropylene, and polyesters of dibasic aromatic carboxylic acids with divalent alcohols, such as poly(ethylene terephthalate).

Typical paper supports are those which are partially acetylated or coated with baryta and/or a polyolefin, particularly a poly-$\alpha$-olefin containing 2 to 10 carbon atoms, such as polyethylene, polypropylene, as well as copolymers, e.g., of ethylene and propylene.

Further details of useful supports can be found in *Research Disclosure,* Vol. 176, Publication No. 17643, Para. XVII (Dec. 1978), published by Industrial Opportunities Ltd., Homewell, Havant, Hampshire, PO9, IEF, United Kingdom.

In a highly preferred embodiment of the invention a photopolymerizable composition containing a co-initiator composition of the invention is coated on a metallic support, preferably along with a polymeric binder. Particularly preferred metallic supports are copper foil or a silicon chip. Such elements are useful in microelectronics and photofabrication, where the foil or chip is etched into

desired configurations. In such uses, the photopolymerizable composition together with a binder, acts as a negative resist that is exposed and developed to form a resist image.

When binders are desired as an additional component, they can be selected from addition polymers, e.g., homopolymers, copolymers and terpolymers of vinyl, especially acrylic monomer; and condensation polymers, e.g., polyesters, polyamides and polysulfonamides, mixtures of the above, and the like. Such binders are not needed, however, even in resist applications, when the polymerizable compound and co-initiator composition are film-forming in and of themselves, e.g, when the polymerizable compound is of a relatively high molecular weight such as an oligomer or a polymer.

Plasticizers can be included in the photopolymerizable compositions of the invention for specific purposes or applications. However, in some cases better speeds are obtained by omitting them.

Additionally, photopolymerizable compositions containing the co-initiators of the invention can be used to manufacture polymeric coatings and other articles of manufacture that are uniformly, rather than imagewise, exposed to activating radiation.

In the following examples, the photopolymerization speeds obtained with various co-initiator compositions are reported relative to the speed obtained with the combination of sensitizers suggested in U.S. Patent 4,147,522. As previously mentioned, the patent suggests that a mixture of the sensitizers: 3 - benzoyl - 7 - methoxycoumarin and 3,3′ - carbonylbis(7 - diethylaminocoumarin) may be useful to increase the speed and spectral response of crosslinkable polymers. Since 3,3′ - carbonylbis(7 - diethylaminocoumarin) contains amino groups, it might be expected to act as an activator in a photopolymerization co-initiator composition. The combination was tested and found to initiate polymerization of acrylic compounds rather poorly. In the following examples, this co-initiator combination was chosen as a "control" and arbitrarily assigned a relative speed of 1.

The following examples illustrate the nature of the invention.

## Examples 1—20

To demonstrate the effectiveness of various alkoxy-substituted 3-acylcoumarin sensitizers with various amine activators, coatings were prepared containing 0.08 millimoles of coumarin and 0.8 millimoles of activator added to 13 milliliter portions of the following solution of the copolymerizable composition:

| | |
|---|---|
| Pentaerythritol tetraacrylate | 45.0 g |
| Pentaerythritol tetramethacrylate | 60.0 g |
| Poly(methyl methacrylate-co-butyl methacrylate-co-acrylic acid) (34:63:3)% available from Rohm & Haas Co. under the Trademark "Acryloid B48N" (binder) | 120.0 g |
| Poly(methyl methacrylate) available from Rohm & Haas Co. under the Trademark "Acryloid A 11" (binder) | 120.0 g |
| t-Butyl 4-hydroxy-5-methylphenyl sulfide (stabilizer) | 1.05 g |
| Dibutyl phthalate (plasticizer) | 50.4 g |
| Dichloromethane (solvent) | 535.2 g |

Each coating solution was coated at a wet thickness of 300 microns on a copper support on a coating block maintained at 18°C. After 5 minutes, the temperature of the block was raised to 66°C for 10 minutes. The strips were then heated in an oven at 90°C for 10 minutes. Test strips were exposed for 180 seconds through a KODAK T—14 step table having optical density increments of 0.15, and a polypropylene cover sheet using a "COLIGHT EXPOSER" device which uses a 400 W medium pressure mercury vapor lamp. The exposed test strips were developed for 55 seconds in a processing bath containing 1,1,1-trichloroethane, rinsed for 5 seconds with fresh 1,1,1-trichloroethane, rinsed with water and dried. The coumarins of Table I and the amines used as co-initiators as well as the relative speeds are indicated in Table III.

TABLE III

| Example No. | Sensitizer | Activator | Rel. Speed |
|---|---|---|---|
| Control | S—1 | S—39 | 1 |
| 1. | S—1 | 4-dimethylaminobenzaldehyde | 38 |
| 2. | S—1 | tridodecylamine | 3 |
| 3. | S—1 | tribenzylamine | 10 |
| 4. | S—1 | 1,5-pentamethylenebis(4-dimethylaminobenzoate | 18 |
| 5. | S—1 | IAA* | 9 |
| 6. | S—1 | NPG** | 15 |
| 7. | S—1 | DAMB*** | 38 |
| 8. | S—3 | DMAB | 40 |
| 9. | S—3 | NPG | 31 |
| 10. | S—4 | DMAB | 26 |
| 11 | S—4 | NPG | 24 |
| 12. | S—5 | DMAB | 44 |
| 13. | S—5 | NPG | 56 |
| 14. | S—6 | DMAB | 44 |
| 15. | S—6 | IAA | 15 |
| 16. | S—6 | NPG | 56 |
| 17. | S—7 | DMAB | 40 |
| 18. | S—7 | NPG | 34 |
| 19. | S—8 | DMAB | 43 |
| 20. | S—8 | NPG | 26 |

* indole-3-ylacetic acid
** N-phenylglycine
*** ethyl 4-dimethylaminobenzoate

From the results reported in Table III, it can be seen that a variety of alkoxy-substituted 3-acylcoumarin sensitizers comprise useful co-initiator compositions with a variety of amine-containing activators. Such compositions provide relative speeds ranging from 3 to 56 in the photopolymerization of a mixture of acrylic monomers.

Examples 21—46

The effectiveness of various amino-substituted 3-acylcoumarin sensitizers from Table II in co-initiator compositions with various amine activators is demonstrated by the following examples. Example 1 was repeated except that the coumarin sensitizers and the activators selected were those indicated in the following Table IV:

TABLE IV

| Example No. | Sensitizer | Activator | Rel. Speed |
|---|---|---|---|
| 21. | S—32 | DMAB* | 5 |
| 22. | S—32 | MBA** | 6 |
| 23. | S—33 | DMAB | 4 |
| 24. | S—34 | DMAB | 1 |
| 25. | S—34 | MBA | 3 |
| 26. | S—35 | DMAB | 15 |
| 27. | S—35 | MBA | 11 |
| 28. | S—36 | DMAB | 15 |
| 29. | S—37 | DMAB | 44 |
| 30. | S—37 | MBA | 31 |
| 31. | S—38 | DMBA | 6 |
| 32. | S—38 | MBA | 8 |
| 33. | S—39 | DMAB | 6 |
| 34. | S—39 | MBA | 5 |
| 35. | S—40 | DMAB | 44 |
| 36. | S—40 | MBA | 31 |
| 37. | S—41 | DMAB | 4 |
| 38. | S—42 | DMAB | 3 |
| 39. | S—43 | DMAB | 4 |
| 40. | S—44 | DMAB | 1 |
| 41. | S—45 | DMAB | 4 |
| 42. | S—46 | DMAB | 3 |
| 43. | S—47 | DMAB | 5 |
| 44. | S—47 | MBA | 8 |
| 45. | S—48 | DMAB | 2 |
| 46. | S—49 | DMAB | 5 |

* ethyl 4-dimethylaminobenzoate
** N-methyl-N-benzylaniline

The results reported in Table IV indicate that a variety of amino-substituted 3-acylcoumarins form useful co-initiator compositions with various activator such as dimethylaminobenzoate esters and tertiary amines.

Examples 47—68

Surprisingly effective co-initiator compositions of this invention comprise amino-substituted-3-acylcoumarin sensitizers with activators which are amino-derivatives of acetic acid as demonstrated by the following examples. Example 1 was repeated except that the coumarin sensitizers and the activators selected were those indicated in the following Table V:

TABLE V

| Example No. | Sensitizer | Activator | Rel. Speed |
|---|---|---|---|
| 47. | S—32 | NPG* | 35 |
| 48. | S—33 | NPG | 28 |
| 49. | S—34 | NPG | 26 |
| 50. | S—35 | NPG | 71 |
| 51. | S—36 | NPG | 50 |
| 52. | S—37 | NPG | 61 |
| 53. | S—37 | IAA** | 15 |
| 54. | S—38 | NPG | 59 |
| 55. | S—39 | NPG | 74 |
| 56. | S—39 | IAA | 8 |
| 57. | S—40 | NPG | 88 |
| 58. | S—41 | NPG | 14 |
| 59. | S—42 | NPG | 55 |
| 60. | S—42 | IAA | 8 |
| 61. | S—43 | NPG | 39 |
| 62. | S—44 | NPG | 20 |
| 63. | S—45 | NPG | 44 |
| 64. | S—45 | IAA | 8 |
| 65. | S—46 | NPG | 18 |
| 66. | S—47 | NPG | 25 |
| 67. | S—48 | NPG | 40 |
| 68. | S—49 | NPG | 45 |

* N-phenylglycine
** indole-3-ylacetic acid

From Table V, it can be seen that advantageous results are obtained with co-initiator compositions containing amino-substituted 3-acylcoumarin sensitizers and amino derivatives of acetic acid as activators.

Examples 69—73

To demonstrate the effectiveness of various other activators in the co-initiator compositions of the invention, Example 1 was repeated except that the 3-acylcoumarin sensitizers and activators were as reported in Table VI as follows:

TABLE VI

| Example No. | Sensitizer | Activator | Rel. Speed |
|---|---|---|---|
| 69. | S—37* | 2,3-bornanedione* | 10 |
| 70. | S—6 | triphenylphosphine | 7 |
| 71. | S—6 | tritolylphosphine | 4 |
| 72. | S—6 | triphenylstibine | 4 |
| 73. | S—39 | fluorenone | 8 |

* 0.1 m mole was used.

Examples 74—78

To demonstrate the use of the co-initiator compositions of this invention to photopolymerize various monomers, a stock solution was prepared as follows:

| | |
|---|---|
| Poly(methyl acrylate-co-butyl methacrylate-co-acrylic acid) (34:63:3)% available from Rohm & Haas Co. under the Trademark "Acryloid B—48N" (binder) | 60 g |
| Poly(methyl methacrylate) available from Rohm & Haas under the Trademark "Acryloid A 11" (binder) | 60 g |
| 3,3'-Carbonylbis(5,7-di-n-propoxycoumarin) (sensitizer) | 1.5 g |
| Ethyl 4-dimethylaminobenzoate (activator) | 1.5 g |
| t-Butyl pyrocatechol (stabilizer) | 0.525 g |
| Dichloromethane (solvent) | 278.6 g |

To separate 39.11 g portions of the stock solution, 5.25 g of the monomer under test was added. Each test solution was coated on 35 $\mu$m thick copper foil strips at a wet thickness of 300 $\mu$m and dried. The dry coatings were approximately 75 $\mu$m thick. The test strips were exposed for 2 minutes through a KODAK T—14 step tablet having optical density increments of 0.15 to a "COLIGHT EXPOSER" device using a 400 W medium pressure mercury lamp. The exposed test strips were spray developed in 1,1,1-trichloroethane for 1 minute and rinsed with water. The speeds obtained with the various coatings are reported in Table VII as the last observed solid step remaining after development.

TABLE VII

| Example No. | Monomer | Speed |
|---|---|---|
| 74. | tetraethylene glycol diacrylate | 12+ |
| 75. | 1,6-hexanediol diacrylate | 10+ |
| 76. | triethylene glycol dimethacrylate | 10— |
| 77. | tetraethylene glycol dimethacrylate | 10 |
| 78. | diethylene glycol dimethacrylate | 9 |

Example 79—89

It was observed that extremely fast speeds could be obtained with certain co-initiator compositions of this invention when a copolymerizable composition described in Example 1 was formulated without the plasticizer, dibutyl phthalate. The sensitizer and activator used and the relative speeds obtained are reported below in Table VIII. In all other respects Example 1 was repeated.

TABLE VIII

| Example No. | Sensitizer | Activator | Rel. Speed |
|---|---|---|---|
| 79. | S—37 | N-methylindole-3-ylacetic acid | 133 |
| 80. | S—37 | DMAB | 54 |
| 81. | S—37 | IAA | 45 |
| 82. | S—6 | DMAB | 44 |
| 83. | S—6 | NPG | 69 |
| 84. | S—6 | IAA | 16 |
| 85. | S—6 | N-methylindole-3-ylacetic acid | 41 |
| 86. | S—9 | DMAB | 71 |
| 87. | S—9 | NPG | 76 |
| 88. | S—45 | N-methylindole-3-ylacetic acid | 64 |
| 89. | S—42 | N-methylindole-3-ylacetic acid | 54. |

**Claims**

1. A co-initiator composition for the photopolymerization of an addition polymerizable compound or mixture of such compounds containing ethylenic unsaturation, comprising a sensitizer which is a photo-excitable aromatic carbonyl compound and an activator compound which is responsive in the presence of a photo-excited form of said carbonyl compound to form a free-radical; characterized in that

a) said aromatic carbonyl compound is a 3-acylcoumarin having the formula:

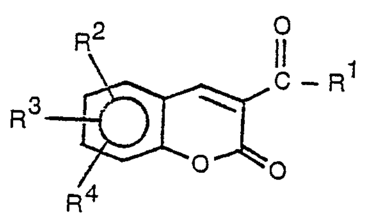

wherein:

$R^1$ is an aromatic carbocyclic or heterocyclic group having from 5 to 20 ring atoms, which aromatic group is conjugated with the carbonyl group either directly or through an alkenylene group;

$R^2$, $R^3$ and $R^4$ are each independently: hydrogen; hydroxy; alkylamino, dialkylamino, or alkoxy containing from 1 to 5 carbon atoms in the alkyl portion; acyloxy; a heterocyclic group of one or more saturated or unsaturated rings containing from 5 to 10 ring atoms; or $R^2$ and $R^3$ and/or $R^3$ and $R^4$, when taken together comprise the non-metallic atoms necessary to complete one or more fused aryl or fused saturated or unsaturated heterocyclic rings containing from 5 to 10 ring atoms; and

b) said activator compound is selected from an amino-derivative of acetic acid, a phosphine, a phosphite, a bismuthine, an arsine, a stibine, a sulfinic acid, a sulfinic acid ester, a sulfone, 9-fluorenone, 1,3-bornanedione and an amine according to one of the formulas:

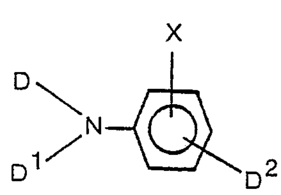

or

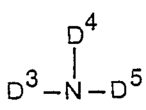

wherein:

D and $D^1$ are each independently an alkyl group having from 1 to 12 carbon atoms or, when taken

together, the atoms necessary to complete a heterocyclic group having from 5 to 10 nuclear atoms;

$D^2$ is an alkyl group having from 1 to 3 carbon atoms, a hydroxylalkyl group, a formyl group, a

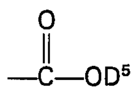 group, or a 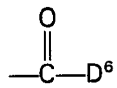

group;

$D^3$ is hydrogen, an alkyl group having from 1 to 12 carbon atoms, an aralkyl group having from 1 to 3 carbon atoms in the alkyl portion and from 6 to 10 carbon atoms in the aryl portion;

$D^4$ is an alkyl group having from 1 to 12 carbon atoms or an aralkyl group having from 1 to 12 atoms in the alkyl portion and from 6 to 10 carbon atoms in the aryl portion;

$D^5$ is an aryl group having from 6 to 10 carbon atoms, an alkyl group having from 1 to 15 carbon atoms, or an alkyl group substituted with an aryl group, a 2-phthalimido group, a methacryloyloxy group or a group of the formula

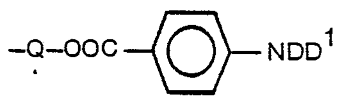

wherein D and $D^1$ are as defined above and Q is a linking group,

$D^6$ is hydrogen, an alkyl group having from 1 to 3 carbon atoms, an aryl group having from 6 to 10 nuclear carbon atoms or a $—CH_2COOD^7$ group wherein $D^7$ is hydrogen or an alkyl group having from 1 to 3 carbon atoms; and

X is hydrogen or a halogen,

all carbocyclic, heterocyclic and aryl groups in a) and b) being optionally substituted and all alkenyl groups being optionally substituted by aryl or alkyl.

2. A co-initiator composition according to claim 1, characterized in that $R^2$, $R^3$ and $R^4$ are each independently hydrogen; a dialkylamino group having from 1 to 5 carbon atoms in the alkyl portions; a heterocyclic amino group having from 5 to 10 nuclear atoms; or $R^2$ and $R^3$ and/or $R^3$ and $R^4$, when taken together, comprise the non-metallic atoms necessary to complete one or more fused saturated or unsaturated nitrogen-containing heterocyclic rings; having from 5 to 10 nuclear atoms provided that at least one of $R^2$, $R^3$ and $R^4$ is other than hydrogen.

3. A co-initiator composition according to claim 1, characterized in that the sensitizer is 3 - benzoyl - 7 - methoxycoumarin; 7 - methoxy - 3 - (4 - nitro - benzoyl)coumarin; 3 - (4 - fluorosulfonylbenzoyl) - 7 - methoxycoumarin; 3 - benzoyl - 5,7 - di - n - propoxycoumarin; 3 - (4 - cyanobenzoyl) - 5,7 - di - n - propoxycoumarin; 3 - (4 - methoxybenzoyl) - 5,7 - di - n - propoxycoumarin; 3 - (4 - nitrobenzoyl) - 5,7 - di - n - propoxycoumarin; 3 - (3 - trifluoromethylbenzoyl) - 5,7 - di - n - propoxycoumarin; 3 - benzoyl - 5,7 - dimethoxycoumarin; 3 - benzoyl - 5,7 - diethoxycoumarin; 3 - benzoyl - 6 - methoxycoumarin; 3 - benzoyl - 8 - ethoxycoumarin; 3 - benzoylbenzo[f] coumarin; 3 - benzoyl - 7 - hydroxycoumarin; 3 - (4 - ethoxybenzoyl) - 7 - methoxycoumarin; 7 - acetoxy - 3 - benzoylcoumarin; 7 - methoxy - 3 - (4 - methoxybenzoyl)-coumarin; 3 - benzoyl - 7 - diethylaminocoumarin; 7 - diethylamino - 3 - (4 - iodobenzoyl)-coumarin; 7 - diethylamino - 3 - (4 - dimethylaminobenzoyl)coumarin; 7 - diethylamino - 3 - (2 - methoxybenzoyl)coumarin; 7 - diethylamino - 3 - (3 - fluorosulfonylbenzoyl)coumarin; 3 - (4 - cyanobenzoyl) - 7 - diethylaminocoumarin; 3 - benzoyl - 7 - dimethylaminocoumarin; 3 - benzoyl - 7 - pyrrolidinylcoumarin; 7 - dimethylamino - 3 - (4 - iodobenzoyl)coumarin; 7 - dimethylamino - 3 - (4 - dimethylaminobenzoyl)coumarin; or 7 - diethylamino - 3 - (4 - nitrobenzoyl coumarin.

4. A co-initiator composition according to claim 1, characterized in that the sensitizer is 3,3′ - carbonylbis(5,7 - diethoxycoumarin); 3,3′ - carbonylbis - (5,7 - di - n - propoxycoumarin); 3,3′ - carbonylbis(5,7 - dibutoxycoumarin); 3,3′ - carbonylbis(7 - acetoxycoumarin); 3,3′ - carbonylbis(5,7,7′ - trimethoxycoumarin); 3,3′ - carbonylbiscoumarin; 3,3′ - carbonylbis(7 - methoxycoumarin); 3,3′ - carbonylbis(6 - methoxycoumarin); 3,3′ - carbonylbis(5,7 - dimethoxycoumarin; 3,3′ - carbonylbis(5,7 - di - isopropoxycoumarin); or 3,3′ - carbonylbis(7 - diethylaminocoumarin).

5. A co-initiator composition according to claim 1, characterized in that the sensitizer is 3 - (4 - ethoxycinnamoyl) - 7 - methoxycoumarin; 3 - cinnamoyl - 7 - diethylaminocoumarin; 3 - (4 - diethylaminocinnamoyl) - 7 - diethylaminocoumarin; 7 - diethylamino - 3 - (4 - morpholinocinnamoyl)coumarin; 7 - diethylamino - 3 - (4 - dimethylaminocinnamylideneacetyl)coumarin; 7 - diethylamino - 3 - (4 - ethoxycinnamoyl)coumarin; 3 - (4 - bromocinnamoyl) - 7 - diethylaminocoumarin; 7 - diethylamino - 3 - [3 - (4 - methoxy - 1 - naphthyl) - acryloyl]coumarin; or 7 - diethylamino - 3 - cinnamylideneacetylcoumarin.

6. A co-initiator composition according to claim 1, characterized in that the sensitizer is 5,7 - diethoxy - 3 - (2 - thenoyl)coumarin; 7 - dimethylamino - 3 - (2 - thenoyl)coumarin; 7 - dimethylamino - 3 - [3 - (2 - thienyl)acryloyl]coumarin; 7 - dimethylamino - 3 - [3 - (2 - thienyl)-

acryloyl]coumarin; 7 - diethylamino - 3 - (2 - thenoyl)coumarin; or 7 - pyrrolidinyl - 3 - (2 - thenoyl)coumarin.

7. A co-initiator composition according to claim 1, characterized in that the sensitizer is 3 - (2 - benzofuroyl) - 5,7 - diethoxycoumarin; 7 - diethylamino - 3 - (2 - furoyl)coumarin; 3 - (2 - benzofuroyl) - 7 - diethylaminocoumarin; 3 - (2 - benzofuroyl) - 7 - (1 - pyrrolidinyl)coumarin; or 3 - (2' - benzofuroyl)acryloyl - 7 - diethylaminocoumarin.

8. A co-initiator composition according to claim 1, characterized in that the sensitizer is 9 - (4 - diethylaminocinnamoyl) - 1,2,4,5 - tetrahydro - 3H,6H,10H[1]benzopyrano[6,7,8 - quinolizine - 10 - one; 9 - [3 - (9 - julolidyl)acryloyl] - 1,2,4,5 - tetrahydro - 3H,6H,10H[1]-benzopyrano[6,7,8 - ij] - quinolizine - 10 - one; 9 - (7 - n - propylamino - 3 - coumarinoyl) - 1,2,4,5 - tetrahydro - 3H,6H,10H[1]benzopyrano[6,7,8 - ij] - quinolizine - 10 - one; 9 - (7 - diethylamino - 3 - coumarinoyl) - 1,2,4,5 - tetrahydro - 3H,6H,10H[1]benzopyrano[6,7,8 - ij] - quinolizine - 10 - one; or 9 - [3 - (2 - thienyl)acryloyl] - 1,2,4,5 - tetrahydro - 3H,6H,10H[1]benzopyrano[6,7,8 - ij]quinolizine - 10 - one.

9. A co-initiator composition according to claim 1, characterized in that said activator is ethyl 4 - dimethylaminobenzoate; n-butyl 4-dimethylaminobenzoate; phenethyl 4-dimethylaminobenzoate; 2-phthalimidoethyl 4-dimethylaminobenzoate; 2-methacryloyloxyethyl 4-dimethylaminobenzoate; 1,5 - pentamethylenebis(4 - dimethylamino)benzoate; 4,4' - (dimethylamino)benzophenone; phenethyl 3 - dimethylaminobenzoate; 1,5 - pentamethylenebis(3 - dimethylamino)benzoate; 4 - dimethylaminobenzaldehyde; 4 - dimethylaminoacetophenone; 4 - N - piperidinoacetophenone; or 4 - dimethylaminobenzoin.

10. A co-initiator composition according to claim 1, characterized in that said activator is 4-dimethylaminobenzyl alcohol; ethyl 4-dimethylaminobenzyl acetate; tribenzylamine; or N,N-dibenzylaniline.

11. A co-initiator composition according to claim 1, characterized in that said activator is N,N-dimethyl-4-toluidine; N,N-diethyl-3-phenetidine; or 4-bromo-N,N-dimethylaniline.

12. A co-initiator composition according to claim 1, characterized in that said activator is tridodecylamine.

13. A co-initiator composition according to any one of claims 1 to 8, characterized in that said activator compound is an amino-derivative of acetic acid having one of the formulas:

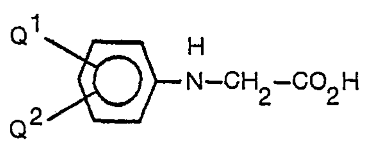

or

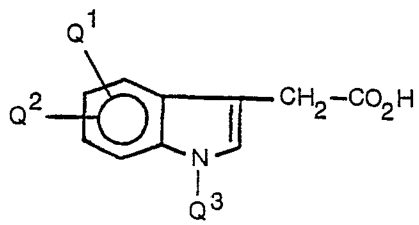

wherein $Q^1$ and $Q^2$ are each independently hydrogen; an alkyl, alkoxy or alkylthio group having from 1 to 5 carbon atoms; an aryl, aryloxy or aroyloxy group having from 6 to 10 carbon atoms; a hydroxy group; a halogen; or, when taken together, the atoms necessary to complete a fused heterocyclic or aromatic ring having from 4 to 6 nuclear atoms; and $Q^3$ is hydrogen; or an alkyl group having from 1 to 5 carbon atoms.

14. A co-initiator composition according to claim 13, characterized in that said activator is N-phenylglycine, indole-3-ylacetic acid or N-methylindole-3-ylacetic acid.

15. A co-initiator composition according to claim 14, characterized in that said sensitizer is 3 - (2 - benzofuroyl) - 7 - (1 - pyrrolidinyl)coumarin; 3 - (4 - diethylaminocinnamoyl) - 7 - diethylaminocoumarin; 3 - (2 - benzofuroyl) - 7 - diethylaminocoumarin; 3,3' - carbonylbis(7 - diethylaminocoumarin); or 3,3' - carbonylbis(5,7 - di - n - propoxycoumarin).

16. A photopolymerizable composition comprising an addition polymerizable compound or mixture of such compounds containing ethylenic unsaturation, and a co-initiator composition according to claim 1.

17. A photographic element comprising a support bearing a layer of a photopolymerizable composition comprising an addition polymerizable compound or mixture of such compounds containing ethylenic unsaturation and a co-initiator according to claim 1.

**Patentansprüche**

1. Co-Initiator-Masse für die Photopolymerisation einer einer Additionspolymerisation zugänglichen ethylenisch ungesättigten Verbindung oder eines Gemisches von solchen Verbindungen mit einem Sensibilisator aus einer photoanregbaren aromatischen Carbonylverbindung und einer Aktivatorverbindung, die in Gegenwart einer photoangeregten Form der Carbonylverbindung ein freies Radikal zu erzeugen vermag, dadurch gekennzeichnet, daß

a) die aromatische Carbonylverbindung ein 3-Acylcoumarin der folgenden Formel ist:

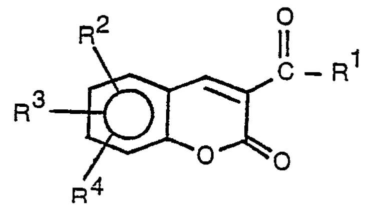

(I)

in der bedeuten:

$R^1$ ein aromatische carbocyclische oder heterocyclische Gruppe mit 5 bis 20 Ringatomen, die mit der Carbonylgruppe entweder direkt oder durch eine Alkenylgruppe konjugiert ist;

$R^2$, $R^3$ und $R^4$ unabhängig voneinander: Wasserstoff, Hydroxy, Alkylamino, Dialkylamino oder Alkoxy mit 1 bis 5 Kohlenstoffatomen in Alkylrest; Acyloxy; eine heterocyclische Gruppe aus einem oder mehreren gesättigten oder ungesättigten Ringen mit 5 bis 10 Ringatomen; oder $R^2$ und $R^3$ und/oder $R^3$ und $R^4$ gemeinsam die nichtmetallischen Atome, die zur Vervollständigung von einem oder mehreren ankondensierten Arylringen oder ankondensierten gesättigten oder ungesättigten heterocyclischen Ringen mit 5 bis 10 Ringatomen erforderlich sind, und daß

b) die Aktivatorverbindung ausgewählt ist aus einem Aminoderivat der Essigsäure, einem Phosphin, einem Phosphit, einem Wismutin, einem Arsin, einem Stibin, einer Sulfinsäure, einem Sulfinsäureester, einem Sulfon, einem 9-Fluorenon, 2,3-Bornandion und einem Amin gemäß einer der folgenden Formeln:

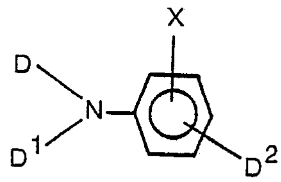

oder

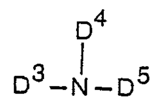

worin bedeuten:

D und $D^1$ jeweils unabhängig voneinander eine Alkylgruppe mit 1 bis 12 Kohlenstoffatomen oder gemeinsam die Atome, die zur Vervollständigung einer heterocyclischen Gruppe mit 5 bis 10 Kernatomen erforderlich sind;

$D^2$ eine Alkylgruppe mit 1 bis 3 Kohlenstoffatomen, eine Hydroxyalkylgruppe, eine Formylgruppe, eine

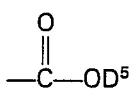

Gruppe oder eine

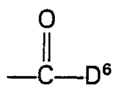

Gruppe;

$D^3$ Wasserstoff, eine Alkylgruppe mit 1 bis 12 Kohlenstoffatomen, eine Aralkylgruppe mit 1 bis 3 Kohlenstoffatomen im Alkylrest und 6 bis 10 Kohlenstoffatomen im Arylrest;

$D^4$ eine Alkylgruppe mit 1 bis 12 Kohlenstoffatomen oder eine Aralkylgruppe mit 1 bis 12 Kohlenstoffatomen im Alkylrest und 6 bis 10 Kohlenstoffatomen im Arylrest;

$D^5$ eine Arylgruppe mit 6 bis 10 Kohlenstoffatomen, eine Alkylgruppe mit 1 bis 15 Kohlenstoffatomen oder eine Alkylgruppe, substituiert mit einer Arylgruppe, eine 2-Phthalimidogruppe, eine Methoxyacryloyloxygruppe oder eine Gruppe der Formel:

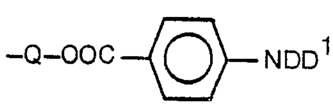

in der D und $D^1$ die oben angegebene Bedeutung haben und Q für ein Bindeglied steht;

$D^6$ Wasserstoff, eine Alkylgruppe mit 1 bis 3 Kohlenstoffatomen, eine Arylgruppe mit 6 bis 10 Kernkohlenstoffatomen oder eine Gruppe der Formel $—CH_2COOD^7$, wobei $D^7$ für Wasserstoff oder eine Alkylgruppe mit 1 bis 3 Kohlenstoffatomen steht und

X Wasserstoff oder ein Halogen,

wobei gilt, daß sämtliche carbocyclischen und heterocyclischen Gruppen sowie Arylgruppen in a) und b) gegebenenfalls substituiert sein können und sämtliche Alkenylgruppen gegebenenfalls durch Aryl- oder Alkylgruppen substituiert sein können.

2. Co-Initiator-Masse nach Anspruch 1, dadurch gekennzeichnet, daß $R^2$, $R^3$ und $R^4$ jeweils unabhängig voneinander darstellen: Wasserstoff, eine Dialkylaminogruppe mit 1 bis 5 Kohlenstoffatomen in den Alkylresten; eine heterocyclische Aminogruppe mit 5 bis 10 Kernatomen; oder $R^2$ und $R^3$ und/oder $R^3$ und $R^4$ gemeinsam die nicht-metallischen Atome, die zur Vervollständigung von einem oder mehreren kondensierten gesättigten oder ungesättigten Stickstoff enthaltenden heterocyclischen Ringen erforderlich sind, die 5 bis 10 Ringatome aufweisen, wobei gilt, daß mindestens einer der Reste $R^2$, $R^3$ und $R^4$ von Wasserstoff verschieden ist.

3. Co-Initiator-Masse nach Anspruch 1, dadurch gekennzeichnet, daß der Sensibilisator besteht aus: 3 - Benzoyl - 7 - methoxycoumarin; 7 - Methoxy - 3 - (4 - nitro - benzoyl) - coumarin; 3 - (4 - Fluorosulfonylbenzoyl) - 7 - methoxycoumarin; 3 - Benzoyl - 5,7 - di - n - propoxycoumarin; 3 - (4 - Cyanobenzoyl) - 5,7 - di - n - propoxycoumarin; 3 - (4 - Methoxybenzoyl - 5,7 - di - n - propoxycoumarin; 3 - (4 - Nitrobenzoyl) - 5,7 - di - n - propoxycoumarin; 3 - (3 - Trifluoromethylbenzoyl) - 5,7 - di - n - propoxycoumarin; 3 - Benzoyl - 5,7 - dimethoxycoumarin; 3 - Benzoyl - 5,7 - diethoxycoumarin; 3 - Benzoyl - 6 - methoxycoumarin; 3 - Benzoyl - 8 - ethoxycoumarin; 3 - Benzoylbenzo[f]coumarin; 3 - Benzoyl - 7 - hydroxycoumarin; 3 - (4 - Ethoxybenzoyl) - 7 - methoxycoumarin; 7 - Acetoxy - 3 - benzoylcoumarin; 7 - Methoxy - 3 - (4 - methoxybenzoyl)coumarin; 3 - Benzoyl - 7 - diethylaminocoumarin; 7 - Diethylamino - 3 - (4 - iodobenzoyl)coumarin; 7 - Diethylamino - 3 - (4 - dimethylaminobenzoyl)coumarin; 7 - Diethylamino - 3 - (2 - methoxybenzoyl) - coumarin; 7 - Diethylamino - 3 - (3 - fluorosulfonylbenzoyl) - coumarin; 3 - (4 - Cyanobenzoyl) - 7 - diethylaminocoumarin; 3 - Benzoyl - 7 - dimethylaminocoumarin; 3 - Benzoyl - 7 - pyrrolidinylcoumarin; 7 - Dimethylamino - 3 - (4 - iodobenzoyl) - coumarin; 7 - Dimethylamino - 3 - (4 - dimethylaminobenzoyl) - coumarin oder 7 - Diethylamino - 3 - (4 - nitrobenzoyl)coumarin.

4. Co-Initiator-Masse nach Anspruch 1, dadurch gekennzeichnet, daß der Sensibilisator besteht aus:

3,3′ - Carbonylbis(5,7 - diethoxycoumarin); 3,3′ - Carbonylbis(5,7 - di - n - propoxycoumarin); 3,3′ - Carbonylbis(5,7 - di - butoxycoumarin); 3,3′ - Carbonylbis(7 - acetoxycoumarin); 3,3′ - Carbonylbis(5,7,7′ - trimethoxycoumarin); 3,3′ - Carbonylbiscoumarin; 3,3′ - Carbonylbis(7 - methoxycoumarin); 3,3′ - Carbonylbis(6 - methoxycoumarin); 3,3′ - Carbonylbis(5,7 - dimethoxycoumarin; 3,3′ - Carbonylbis(5,7 - diisopropoxycoumarin) oder 3,3′ - Carbonylbis(7 - diethylaminocoumarin).

5. Co-Initiator-Masse nach Anspruch 1, dadurch gekennzeichnet, daß der Sensibilisator besteht aus:

3 - (4 - Ethoxycinnamoyl) - 7 - methoxycoumarin; 3 - Cinnamoyl - 7 - diethylaminocoumarin; 3 - (4 - Diethylaminocinnamoyl) - 7 - di - ethylaminocoumarin; 7 - Diethylamino - 3 - (4 - morpholinocinnamoyl)coumarin; 7 - Diethylamino - 3 - (4 - dimethylaminocinnamylidenacetyl)coumarin; 7 - Diethylamino - 3 - (4 - ethoxycinnamoyl)coumarin; 3 - (4 - Bromocinnamoyl) - 7 - di - ethylaminocoumarin; 7 - Diethylamino - 3 - [-(4 - methoxy - 1 - naphthyl) - acryloyl]coumarin oder 7 - Diethylamino - 3 - cinnamylidenacetylcoumarin.

6. Co-Initiator-Masse nach Anspruch 1, dadurch gekennzeichnet, daß der Sensibilisator besteht aus:

5,7 - Diethoxy - 3 - 3(2 - thenoyl)coumarin; 7 - Dimethylamino - 3 - (2 - thenoyl)coumarin; 7 - Dimethylamino - 3 - [3 - (2 - thienyl) - acryloyl]coumarin; 7 - Dimethylamino - 3 - [3 - (2 - thienyl) - acryloyl]coumarin; 7 - Diethylamino - 3 - (2 - thenoyl)coumarin oder 7 - Pyrrolidinyl - 3 - (2 - thenoyl) - coumarin.

7. Co-Initiator-Masse nach Anspruch 1, dadurch gekennzeichnet, daß der Sensibilisator besteht aus:

3 - (2 - Benzofuroyl) - 5,7 - diethoxycoumarin; 7 - Diethylamino - 3 - (2 - furoyl)coumarin; 3 - (2 - Benzofuroyl) - 7 - diethylaminocoumarin; 3 - (2 - Benzofuroyl) - 7 - (1 - pyrrolidinyl)-coumarin oder 3 - (2 - Benzofuroyl)acryloyl - 7 - diethylaminocoumarin.

8. Co- Initiator-Masse nach Anspruch 1, dadurch gekennzeichnet, daß der Sensibilisator besteht aus:

9 - (4 - Diethylaminocinnamoyl) - 1,2,4,5 - tetrahydro - 3H,6H,10H[1]benzopyrano[6,7,8 - ij]chinolizin - 10 - on; 9 - [3 - (9 - Julolidyl)acryloyl] - 1,2,4,5 - tetrahydro - 3H,6H,10H[1]benzopyrano[6,7,8 - ij]chinolizin - 10 - on; 9 - (7 - n - Propyl - amino - 3 - coumarinoyl) - 1,2,4,5 - tetrahydro - 3H,6H,10H[1]benzopyrano[6,7,8 - ij] - chinolizin - 10 - on; 9 - (7 - Diethylamino - 3 - coumarinoyl) - 1,2,4,5 - tetrahydro - 3H,6H,10H[1]benzopyrano[6,7,8 - ij] - chinolizin - 10 - on oder 0 - [3 - (2 - Thienylacryloyl] - 1,2,4,5 - tetrahydro - 3H,6H,10H[1]benzopyrano[6,7,8 - ij]-chinolizin - 10 - on.

9. Co-Initiator-Masse nach Anspruch 1, dadurch gekennzeichnet, daß der Aktivator besteht aus:

Ethyl - 4 - dimethylaminobenzoat; n - Butyl - 4 - dimethylaminobenzoat; Phenethyl - 4 - dimethylaminobenzoat; 2 - Phthalimidoethyl - 4 - dimethylaminobenzoat; 2 - Methacryloyloxyethyl - 4 - dimethylaminobenzoat; 1,5 - Pentamethylenbis(4 - di - methylamino)benzoat; 4,4′ - (Dimethylamino)benzophenon; Phenethyl - 3 - dimethylaminobenzoat; 1,5 - Pentamethylenbis(3 - dimethylamino)benzoat; 4 - Dimethylaminobenzaldehyd; 4 - Dimethylaminoacetophenon; 4 - N - Piperidinoacetophenon oder 4 - Dimethylaminobenzoin.

10. Co-Initiator-Masse nach Anspruch 1, dadurch gekennzeichnet, daß der Aktivator besteht aus:

4-Dimethylaminobenzylalkohol; Ethyl-4-dimethylaminobenzylacetat; Tribenzylamin oder N,N-Dibenzylanilin.

11. Co-Initiator-Masse nach Anspruch 1, dadurch gekennzeichnet, daß der Aktivator besteht aus:

N,N-Dimethyl-4-toluidin; N,N-Diethyl-3-phenetidin oder 4-Bromo-N,N-dimethylanilin.

12. Co-Initiator-Masse nach Anspruch 1, dadurch gekennzeichnet, daß der Aktivator aus Tridodecylamin besteht.

13. Co-Initiator-Masse nach einem der Ansprüche 1 bis 8, dadurch gekennzeichnet, daß die Aktivatorverbindung aus einem Aminoderivat der Essigsäure mit einer der Formeln:

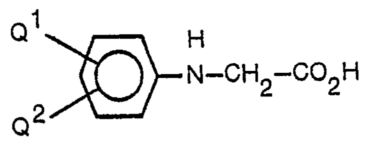

oder

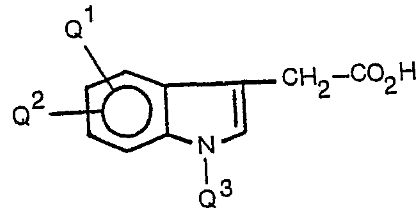

besteht, worin bedeuten:

$Q^1$ und $Q^2$ jeweils unabhängig voneinander Wasserstoff; eine Alkyl-, Alkoxy- oder Alkylthiogruppe mit 1 bis 5 Kohlenstoffatomen; eine Aryl-, Aryloxy- oder Aroyloxygruppe mit 6 bis 10 Kohlenstoffatomen; eine Hydroxygruppe oder ein Halogen oder gemeinsam die zur Vervollständigung eines ankondensierten heterocyclischen oder aromatischen Ringes mit 4 bis 6 Kernatomen erforderlichen Atome und

$Q^3$ Wasserstoff oder eine Alkylgruppe mit 1 bis 5 Kohlenstoffatomen.

14. Co-Initiator-Masse nach Anspruch 13, dadurch gekennzeichnet, daß der Aktivator besteht aus:

N-Phenylglycin, Indol-3-yl-essigsäure oder N-Methylindol-3-yl-essigsäure.

15. Co-Initiator-Masse nach Anspruch 14, dadurch gekennzeichnet, daß der Sensibilisator besteht aus:

3 - (2 - Benzofuroyl) - 7 - (1 - pyrrolidinyl)coumarin; 3 - (4 - Diethylaminocinnamoyl) - 7 - diethylaminocoumarin; 3 - (2 - Benzofuroyl) - 7 - diethylaminocoumarin; 3,3' - Carbonylbis - (7 - diethylaminocoumarin) oder 3,3' - Carbonylbis(5,7 - di - n - propoxycoumarin).

16. Photopolymerisierbare Masse mit einer einer Additionspolymerisation zugänglichen, ethylenisch ungesättigten Verbindung oder Mischung von solchen Verbindungen und einer Co-Initiator-Masse gemäß Anspruch 1.

17. Photographisches Element mit einem Träger mit einer Schicht aus einer photopolymerisierbaren Masse mit einer einer Additionspolymerisation zugänglichen, ethylenisch ungesättigten Verbindung oder Mischung von solchen Verbindungen und einer Co-Initiatormasse gemäß Anspruch 1.

## Revendications

1. Composition de co-amorceurs pour la photopolymérisation d'un composé, ou d'un mélange de composés, polymérisables par addition et contenant une insaturation éthylénique, composition qui comprend un sensibilisateur, qui est un composé carbonyle aromatique photo-excitable, et un activateur qui, en réponse à la présence d'une forme photo-excitée du dit composé carbonyle, forme un radical libre, caractérisée en ce que

a) ce composé carbonyle aromatique est une 3-acylcoumarine correspondant à la formule:

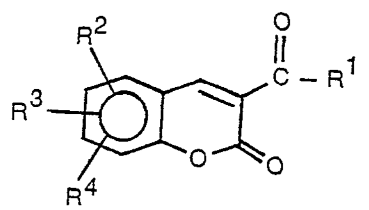

où:

$R^1$ est un groupe aromatique, carbocyclique. ou hétérocyclique, de 5 à 20 atomes dans le noyau, ce groupe aromatique étant conjugué avec le groupe carbonyle, soit directement, soit par l'intermédiaire d'un groupe alkénylène,

$R^2$, $R^3$ et $R^4$ sont chacun, indépendamment, un atome d'hydrogène, un groupe hydroxy, alkylamino, dialkylamino ou alkoxy, avec 1 à 5 atomes de carbone dans le radical alkyle; acyloxy; hétérocyclique avec un ou plusieurs cycles saturés ou insaturés contenant 5 à 10 atomes dans le cycle, ou $R^2$ et $R^3$ et/ou $R^3$ et $R^4$, considérés ensemble, comprennent les atomes non métalliques nécessaires pour compléter un ou plusieurs noyaux aryle condensés ou hétérocycliques saturés ou insaturés condensés contenant 5 à 10 atomes dans le noyau, et,

b) le dit composé activateur est choisi parmi un dérivé aminé de l'acide acétique, une phosphine, un phosphite, une bismuthine, une arsine, une stibine, un acide sulfinique, un ester d'un acide sulfinique, une sulfone, la 9-fluorénone, la 2,3-bornanedione et une amine correspondant à l'une des formules suivantes:

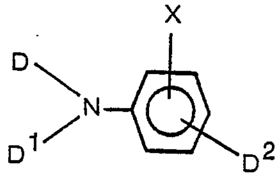

ou

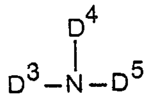

où:

D et $D^1$ sont chacun, indépendamment, un groupe alkyle de 1 à 12 atomes de carbone, ou considérés ensemble, les atomes nécessaires pour compléter un groupe hétérocyclique ayant 5 à 10 atomes dans le noyau;

$D^2$ est un groupe alkyle de 1 à 3 atomes de carbone, un groupe hydroxyalkyle, un groupe formyle, un groupe

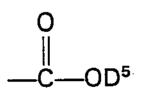

ou

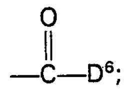;

$D^3$ est un atome d'hydrogène, un groupe alkyle de 1 à 12 atomes de carbone, un groupe aralkyle dont la partie alkyle contient 1 à 3 atomes de carbone et la partie aryle 6 à 10 atomes de carbone,

$D^4$ est un groupe alkyle de 1 à 12 atomes de carbone ou un groupe aralkyle dont la partie alkyle contient 1 à 12 atomes de carbone et la partie aryle 6 à 10 atomes de carbone,

$D^5$ est un groupe aryle de 6 à 10 atomes de carbone, un groupe alkyle de 1 à 15 atomes de carbone ou un groupe alkyle substitué par un groupe aryle, un groupe 2-phtalimido, un groupe méthacryloyloxy ou un groupe correspondant à la formule:

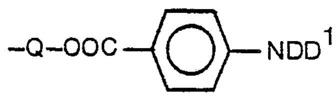

où D et $D^1$ ont les significations précitées et Q est un groupe de liaison;

$D^6$ est un atome d'hydrogène, un groupe alkyle de 1 à 3 atomes de carbone, un groupe aryle ayant 6 à 10 atomes de carbone dans le noyau ou un groupe $-CH_2COOD^7$ où $D^7$ est un atome d'hydrogène ou un groupe alkyle de 1 à 3 atomes de carbone; et,

X est un atome d'hydrogène ou d'halogène,

tous les groupes carbocycliques, hétérocycliques et aryle définis sous a) et b) pouvant être substitués et tous les groupes alkényle pouvant être substitués par des groupes aryle ou alkyle.

2. Composition de co-amorceurs conforme à la revendication 1, caractérisé en ce que $R^2$, $R^3$ et $R^4$ sont chacun, indépendamment, un atome d'hydrogène, un groupe dialkylamino dont les parties aryle contiennent 1 à 5 atomes de carbone, un groupe amino hétérocyclique ayant 5 à 10 atomes dans le noyau; ou $R^2$ et $R^3$ et/ou $R^3$ et $R^4$, considérés ensemble, comprennent les atomes non métalliques nécessaires pour compléter ou un plusieurs hétérocycles azotés, saturés ou insaturés, condensés, contenant 5 à 10 atomes dans le noyau, à la condition qu'au moins l'un des groupes $R^2$, $R^3$ et $R^4$ soit différent de l'hydrogène.

3. Composition de co-amorceurs conforme à la revendication 1, caractérisée en ce que le sensibilisateur est la 3 - benzoyl - 7 - méthoxycoumarine, 7 - méthoxy - 3 - (4 - nitro - benzoyl)-coumarine, 3 - (4 - fluorosulfonylbenzoyl) - 7 - méthoxycoumarine, 3 - benzoyl - 5,7 - di - n - propoxycoumarine, 3 - (4 - cyanobenzoyl) - 5,7 - di - n - propoxycoumarine, 3 - (4 - méthoxy-benzoyl) - 5,7 - di - n - propoxycoumarine, 3 - (4 - nitrobenzoyl) - 5,7 - di - n - propoxycoumarine, 3 - (3 - trifluorométhylbenzoyl) - 5,7 - di - n - propoxycoumarine, 3 - benzoyl - 5,7 - diméthoxycoumarine, 3 - benzoyl - 5,7 - diéthoxycoumarine, 3 - benzoyl - 6 - méthoxycoumarine, 3 - benzoyl - 8 - éthoxycoumarine, 3 - benzoylbenzo[f]coumarine, 3 - benzoyl - 7 - hydroxy-coumarine, 3 - (4 - éthoxybenzoyl) - 7 - méthoxycoumarine, 7 - acétoxy - 3 - benzoylcoumarine, 7 - méthoxy - 3 - (4 - méthoxybenzoyl)coumarine, 3 - benzoyl - 7 - diéthylaminocoumarine, 7 - diéthylamino - 3 - (4 - iodobenzoyl)coumarine, 7 - diéthylamino - 3 - (4 - diméthylamino-benzoyl)coumarine, 7 - diéthylamino - 3 - (2 - méthoxybenzoyl)coumarine, 7 - diéthylamino - 3 - (3 - fluorosulfonylbenzoyl)coumarine, 3 - (4 - cyanobenzoyl) - 7 - diéthylaminocoumarine, 3 - benzoyl - 7 - diméthylaminocoumarine, 3 - benzoyl - 7 - pyrrolidinylcoumarine, 7 - diméthylamino - 3 - (4 - iodobenzoyl)coumarine, 7 - diméthylamino - 3 - (4 - diméthylaminobenzoyl)-coumarine, ou la 7 - diéthylamino - 3 - (4 - nitrobenzoyl)coumarine.

4. Composition de co-amorceurs conforme à la revendication 1, caractérisée en ce que le sensibilisateur est la 3,3' - carbonylbis(5,7 - diéthoxycoumarine); 3,3' - carbonylbis(5,7 - di - n - propoxycoumarine; 3,3' - carbonylbis(5,7 - di - butoxycoumarine); 3,3' - carbonylbis(7 - acétoxy-coumarine); 3,3' - carbonylbis(5,7,7' - triméthoxycoumarine); 3,3' - carbonylbiscoumarine; 3,3' - carbonylbis(7 - méthoxycoumarine); 3,3' - carbonylbis(6 - méthoxycoumarine); 3,3' - carbonyl-

bis(5,7 - diméthoxycoumarine); 3,3′ - carbonylbis(5,7 - di - isopropoxycoumarine); ou la 3,3′ - carbonylbis(7 - diéthylaminocoumarine).

5. Composition de co-amorceurs conforme à la revendication 1, caractérisée en ce que le sensibilisateur est la 3 - (4 - éthoxycinnamoyl) - 7 - méthoxycoumarine, 3 - cinnamoyl - 7 - di - éthylaminocoumarine, 3 - (4 - diéthylaminocinnamoyl) - 7 - di - éthylaminocoumarine, 3 - (4 - diéthylaminocinnamoyl) - 7 - di - éthylaminocoumarine, 7 - diéthylamino - 3 - (4 - morpholinocinnamoyl)coumarine, 7 - diéthylamino - 3 - (4 - diméthylaminocinnamylideneacétyl)coumarine, 7 - diéthylamino - 3 - (4 - éthoxycinnamoyl)coumarine, 3 - (4 - bromocinnamoyl) - 7 - diéthylaminocoumarine, 7 - diéthylamino - 3 - [3 - (4 - méthoxy - 1 - naphtyl) - acryloyl]coumarine, ou la 7 - diéthylamino - 3 - cinnamylideneacétylcoumarine.

6. Composition de co-amorceurs conforme à la revendication 1, caractérisée en ce que le sensibilisateur est la 5,7 - diéthoxy - 3 - (2 - thénoyl)coumarine, 7 - diméthylamino - 3 - (2 - thénoyl)coumarine, 7 - diméthylamino - 3[3 - (2 - thiényl)acryloyl]coumarine, 7 - diméthylamino - 3 - [3 - (2 - thiényl)acryloyl]coumarine, 7 - diéthylamino - 3 - (2 - thénoyl)coumarine, ou la 7 - pyrrolidinyl - 3 - (2 - thénoyl)coumarine.

7. Composition de co-amorceurs conforme à la revendication 1, caractérisée en ce que le sensibilisateur est la 3 - (2 - benzofuroyl) - 5,7 - diéthoxycoumarine, 7 - diéthylamino - 3 - (2 - furoyl)coumarine, 3 - (2 - benzofuroyl) - 7 - diéthylaminocoumarine 3 - (2 - benzofuroyl) - 7 - (1 - pyrrolidinyl)coumarine ou la 3 - (2 - benzofuroyl)acryloyl - 7 - diéthylaminocoumarine.

8. Composition de co-amorceurs conforme à la revendication 1, caractérisée en ce que le sensibilisateur est la 9 - (4 - diéthylaminocinnamoyl) - 1,2,4,5 - tétrahydro - 3H,6H,10H - [1] - benzopyrano[6,7,8 - ij]quinolizine - 10 - one; 9 - [3 - (9 - julolidyl)acryloyl] - 1,2,4,5 - tétrahydro - 3H,6H,10H[1]benzopyrano[6,7,8 - ij] - quinolizine - 10 - one; 9 - (7 - n - propylamino - 3 - coumarinoyl) - 1,2,4,5 - tétrahydro - 3H,6H,10H[1]benzopyrano[6,7,8 - ij] - quinolizine - 10 - one; 9 - (7 - diéthylamino - 3 - coumarinoyl) - 1,2,4,5 - tétrahydro - 3H,6H,10H[1]benzopyrano[6,7,8 - ij] - quinolizine - 10 - one; ou la 9 - [3 - (2 - thiényl)acryloyl] - 1,2,4,5 - tétrahydro - 3H,6H, 10H[1]benzopyrano[6,7,8 - ij]quinolizine - 10 - one.

9. Composition de co-amorceurs conforme à la revendication 1, caractérisée en ce que le dit activateur est le 4 - diméthylaminobenzoate d'éthyle, le 4 - diméthylaminobenzoate de n-butyle, le 4 - diméthylaminobenzoate de phénéthyle, le 4 - diméthylaminobenzoate de 2 - phtalimidoéthyle; le 4 - diméthylaminobenzoate de 2 - méthacryloyloxyéthyle; le 1,5 - pentaméthylènebis(4 - di - méthylamino)benzoate; la 4,4′ - (diméthylamino)benzophénone; le 3 - diméthylaminobenzoate de phénéthyle; le 1,5 - pentaméthylènebis(3 - diméthylamino)benzoate; la 4 - diméthylaminobenzaldéhyde; la 4 - diméthylaminoacétophénone; la 4 - N - pipéridinoacétophénone; ou la 4 - diméthylaminobenzoïne.

10. Composition de co-amorceurs conforme à la revendication 1, caractérisée en ce que le dit activateur est l'alcool 4-diméthylaminobenzylique; le 4-diméthylaminobenzylacétate d'éthyle; la tribenzylamine; ou la N,N-dibenzylaniline.

11. Composition de co-amorceurs conforme à la revendication 1, caractérisée en ce que le dit activateur est la N,N - diméthyl - 4 - toluidine; N,N - diéthyl - 3 - phénétidine; ou la 4 - bromo - N,N - diméthylaniline.

12. Composition de co-amorceurs conforme à la revendication 1, caractérisée en ce que le dit activateur est la tridodécylamine.

13. Composition de co-amorceurs conforme à l'une quelconque des revendications 1 à 8, caractérisée en ce que le dit activateur est un dérivé aminé de l'acide acétique correspondant à l'une des formules suivantes:

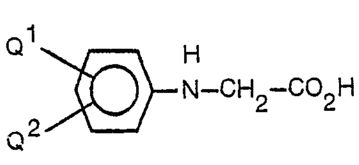

ou

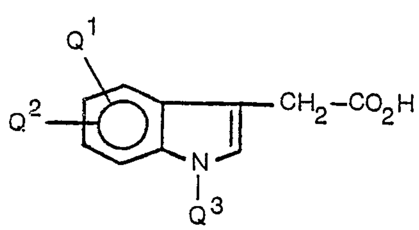

où:

$Q^1$ et $Q^2$ sont chacun, indépendamment, un atome d'hydrogène, un groupe alkyle, alkoxy ou alkylthio ayant 1 à 5 atomes de carbone, un groupe aryle, aryloxy ou aroyloxy ayant 6 à 10 atomes de carbone, un groupe hydroxy, un atome d'halogène, ou $Q^1$ et $Q^2$, considérés ensemble, sont les atomes nécessaires pour compléter un noyau hétérocyclique ou aromatique condensé ayant 4 à 6 atomes dans le noyau et,

$Q^3$ est un atome d'hydrogène ou un groupe alkyle de 1 à 5 atomes de carbone.

14. Composition de co-amorceurs conforme à la revendication 13, caractérisée en ce que le dit activateur est la N-phénylglycine, l'acide indole - 3 - ylacétique ou l'acide N - méthylindole - 3 - ylacétique.

15. Composition de co-amorceurs conforme à la revendication 14, caractérisée en ce que le dit sensibilisateur est la 3 - (2 - benzofuroyl) - 7 - (1 - pyrrolidinyl)coumarine, 3 - (4 - diéthylaminocinnamoyl) - 7 - diéthylaminocoumarine, 3 - (2 - benzofuoryl) - 7 - diéthylaminocoumarine, 3,3′ - carbonylbis(7 - diéthylaminocoumarine), ou la 3,3′ - carbonylbis(5,7 - di - n - propoxycoumarine).

16. Composition photopolymérisable qui comprend un composé ou un mélange de composés polymérisables par addition, contenant une insaturation éthylénique, et une composition de co-amorceurs conforme à la revendication 1.

17. Produit photographique qui comprend un support enduit d'une couche d'une composition photopolymérisable comprenant un composé ou un mélange de composés polymérisables par addition, contenant une insaturation éthylénique, et une composition de co-amorceurs conforme à la revendication 1.